# EUROPÄISCHE PATENTSCHRIFT

(11) **EP 2 219 216 B1**
(45) Veröffentlichungstag und Bekanntmachung des Hinweises auf die Patenterteilung: **15.02.2012**
(21) Anmeldenummer: 09016024.3
(22) Anmeldetag: 24.12.2009
(51) Int. Cl.: H01L 23/24, H01L 23/053, H01L 23/29

(54) **Halbleitermodul**
Semi-conductor module
Module semi-conducteur

(30) Priorität: 16.02.2009 DE 102009000885
(43) Veröffentlichungstag der Anmeldung: 18.08.2010
(73) Patentinhaber: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(56) Entgegenhaltungen:
- EP-A1- 1 857 488
- US-A- 5 436 083
- US-A- 5 436 084
- US-A- 5 474 828
- US-A- 5 776 599
- US-B1- 6 319 740

## Beschreibung

Die Erfindung betrifft ein Halbleitermodul nach dem Oberbegriff des Anspruchs 1.

Ein solches Halbleitermodul ist beispielsweise aus der DE 10 2004 021 927 A1 bekannt. Dabei sind auf einem Substrat aufgenommene Leistungshalbleiter von einem aus einem Polymermaterial hergestellten Gehäuse umgeben. Die herkömmlicherweise zur Herstellung solcher Gehäuse verwendeten Polymermaterialien weisen eine geringe Wärmeleitfähigkeit und Temperaturbeständigkeit auf. Sie sind überdies mit flammenhemmenden Zusätzen versehen, welche insbesondere bei Einwirkung von Feuchtigkeit zu einem Ausfall des Halbleitermoduls führen können.

Das Gehäuse ist üblicherweise zumindest teilweise mit einer elektrisch isolierenden Vergussmasse gefüllt. Die Vergussmasse dient - abgesehen von der elektrischen Isolierung der halbleiternden Bauelemente - einerseits der Befestigung des Gehäuses am Substrat und andererseits zur Ableitung der von den halbleitenden Bauelementen im Betrieb erzeugten Wärme auf das Gehäuse und von da an die Umgebung. Bei dem herkömmlichen Halbleitermodul ist die Wärmeableitung durch die Vergussmasse und das Gehäuse nicht besonders hoch.

Aus der US6,319,740 B1 ist es bekannt ein Multichip-Modul mit einer undurchsichtigen vorzugsweise mehrschichtigen Beschichtung zu versehen, um primär eine optische Inspektion des Schaltkreises zu verhindern. Hierzu ist die erste Beschichtung in Form einer Keramikbeschichtung ausgebildet. Die weiteren Schichten der Beschichtung können zusätzlich, beispielsweise abschirmende, Funktionen übernehmen

Es sind weiterhin beispielhaft aus der US 5,436,084 keramische Ausprägungen von Beschichtungsmassen mit einer Dicke von weniger als einem halben Millimeter bekannt, die der Beschichtung von Substraten dient und hierbei eine Vielzahl von Funktionen erfüllt.

Aufgabe der Erfindung ist es, die Nachteile nach dem Stand der Technik zu beseitigen. Es soll insbesondere ein Halbleitermodul mit verbesserter Wärmeableitung angegeben werden. Nach einem weiteren Ziel der Erfindung soll die Leistung des Halbleitermoduls erhöht werden.

Diese Aufgabe wird durch die Merkmale des Anspruchs 1 gelöst. Zweckmäßige Ausgestaltungen der Erfindung ergeben sich aus den Merkmalen der Ansprüche 2 bis 7.

Nach Maßgabe der Erfindung ist vorgesehen, dass das Polymermaterial eine aus einem präkeramischen Polymer gebildete duroplastische Matrix aufweist. - Das erfindungsgemäß vorgeschlagene Polymermaterial zeichnet sich durch eine erheblich verbesserte Wärmeleitfähigkeit λ aus. Es ist überdies äußerst temperaturstabil. Das vorgeschlagene Halbleitermodul kann mit einer Temperatur von bis zu 300°C betrieben werden. Bei dem vorgeschlagenen Polymermaterial kann auf flammhemmende Zusätze verzichtet werden. Die durch solche Zusätze sich ergebenden Nachteile nach dem Stand der Technik werden vermieden.

Im Sinne der vorliegenden Erfindung wird unter dem Begriff "Substrat" ein z. B. in Form einer Platte vorliegendes elektrisch isolierendes Material verstanden, welches mit Leiterbahnen versehen ist. Darauf kann zumindest ein halbleitendes Bauelement beispielsweise mittels eines Lots, eines Klebstoffs oder dgl. montiert sein. Zum Schutz des so auf dem Substrat aufgenommenen Bauelements wird dieses mit einem "Gehäuse" umgeben. Dabei kann z. B. das Substrat den Boden des Gehäuses bilden, d. h. das Gehäuse muss das halbleitende Bauelement also nicht allseitig umgeben.

Unter dem Begriff "präkeramisches Polymer" wird ein Polymer verstanden, welches z. B. mit zunehmender Temperatur zunächst in einen gelartigen und nachfolgend in einen duroplastischen Zustand übergeht. Im duroplastischen Zustand weist ein präkeramisches Polymer in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosilizane.

Nach einer vorteilhaften Ausgestaltung ist ein Zwischenraum zwischen dem halbleitenden Bauelement und dem das halbleitende Bauelement umgebenden Gehäuse zumindest teilweise mit einer Vergussmasse gefüllt, welche eine aus einem weiteren präkeramischen Polymer gebildete Matrix aufweist. Dabei kann das weitere präkeramische Polymer in gelartiger oder duroplastischer Form vorliegen. Indem anstelle herkömmlicher Vergussmassen nunmehr eine Vergussmasse mit einem weiteren präkeramischen Polymer verwendet wird, kann eine besonders effiziente Wärmeableitung vom halbleitenden Bauelement zum Gehäuse und von da an die Umgebung erfolgen. Das weitere präkeramische Polymer kann nach dem Vergießen beispielsweise durch eine Temperaturbehandlung in einen gelartigen oder auch einen duroplastischen Zustand versetzt werden. Damit kann das Gehäuse fest mit dem Substrat und dem halbleitenden Bauelement verbunden werden.

Nach einer weiteren vorteilhaften Ausgestaltung ist vorgesehen, dass das präkeramische Polymer und/oder das weitere präkeramische Polymer mit einem Füllgrad von bis zu 80 Vol.% mit einem Füllstoff gefüllt ist. Damit können die Wärmeleitfähigkeit und die Viskosität erhöht werden.

Zweckmäßigerweise handelt es sich bei dem Füllstoff um ein aus einem keramischen Material gebildetes Pulver mit einer mittleren Korngröße im Bereich von 0,5 bis 500 µm. Das vorgeschlagene keramische Material ist weitgehend inert. Dessen Zusatz führt nicht zu unerwünschten chemischen Reaktionen. Die vorgeschlagene mittlere Korngröße ermöglicht eine Herstellung des Gehäuses mittels herkömmlicher Gießtechnik, beispielsweise Spritzguss in eine beheizte Form.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit des mit dem keramischen Material gefüllten präkeramischen Polymers bzw. weiteren präkeramischen Polymers auf Werte oberhalb 2 W/mK zu steigern. Damit eignet sich das vorgeschlagene Material insbesondere zur Herstellung eines im Betrieb eine relativ große Wärme freisetzenden Leistungshalbleitermoduls.

Das keramische Material ist zweckmäßigerweise aus der folgenden Gruppe ausgewählt: BN, SiC, Si₃N₄, Steatit, Cordierit. Die vorgeschlagenen keramischen Materialien zeichnen sich durch eine hohe Wärmeleitfähigkeit aus.

Weiterhin hat es sich als zweckmäßig erwiesen, dass das präkeramische Polymer und/oder das weitere präkeramische Polymer aus der folgenden Gruppe ausgewählt ist: Polysiloxan, Polysilazan, Polycarbosilan. Vorteilhafterweise handelt es sich bei dem präkeramischen Material und dem weiteren präkeramischen Material um dasselbe Material. Das vereinfacht die Herstellung. Außerdem kann damit eine besonders gute Verbindung zwischen dem Gehäuse und der Vergussmasse hergestellt werden.

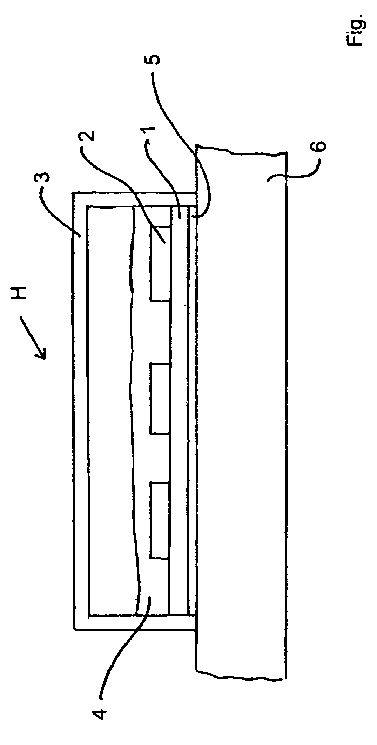

Nachfolgend wird ein Ausführungsbeispiel der Erfindung anhand der einzigen Figur näher erläutert.

Die Figur zeigt eine schematische Querschnittsansicht durch ein Halbleitermodul. Auf einem elektrisch isolierenden Substrat 1, beispielsweise einem DCB-Substrat, sind mehrere halbleitende Bauelemente 2, beispielsweise Leistungshalbleiter, wie die Dioden, Thyristoren, IGBTs, MOSFETs oder Sensorbauelemente, mittels einer Lötverbindung montiert. Die halbleitende Bauelemente 2 sind von einem Gehäuse 3 umgeben. Mit dem Bezugszeichen 4 ist eine Vergussmasse bezeichnet, welche die halbleitenden Bauelemente 2 und das Substrat 1 überdeckt und randlich an eine umlaufende Gehäusewand anschließt. Das so beschaffene Halbleitermodul H ist unter Zwischenschaltung einer Wärmeleitpaste 5 auf einen Kühlkörper 6 montiert.

Das Gehäuse 3 ist hier aus einem präkeramischen Polymer, beispielsweise Polysiloxan, gebildet, welches zu etwa 50 bis 75 Vol.% mit einem Füllstoff gefüllt ist. Bei dem Füllstoff handelt es sich zweckmäßigerweise um ein SiC-Pulver mit einer mittleren Korngröße im Bereich von 1 bis 10 µm. Der Füllstoff ist in das in duroplastischer Form vorliegende präkeramische Polymer eingebettet und verleiht diesem eine hervorragende Wärmeleitfähigkeit von mehr als 10 W/mK.

Die Vergussmasse 4 ist vorteilhafterweise aus einem weiteren präkeramischen Polymer hergestellt. Auch dabei kann es sich um Polysiloxan handeln, welches mit einem Füllgrad von vorzugsweise 50 bis 60 Vol.% mit einem Füllstoff gefüllt ist. Bei dem Füllstoff kann es sich wiederum um ein SiC-Pulver handeln, dessen mittlere Korngröße beispielsweise im Bereich von 1 bis 5 µm liegt. Um eine möglichst niedrige Viskosität der Vergussmasse 4 während des Vergießens zu gewährleisten, ist der Füllgrad und/oder die mittlere Korngröße des Füllstoffs im Allgemeinen kleiner gewählt als bei dem zur Herstellung des Gehäuses 3 verwendeten präkeramischen Polymersystem. Die Vergussmasse 4 wird nach dem Vergießen zweckmäßigerweise z. B. durch Zufuhr thermischer Energie in einen duroplastischen Zustand versetzt. Damit wird das Gehäuse 3 fest mit dem Substrat 1 verklebt. Abgesehen davon wird damit eine hervorragende Wärmeableitung von den halbleitenden Bauelementen 2 über die Vergussmasse 4 auf das Gehäuse 3 und von da in die Umgebung gewährleistet.

### Bezugszeichenliste

- 1: Substrat
- 2: halbleitendes Bauelement
- 3: Gehäuse
- 4: Vergussmasse
- 5: Wärmeleitpaste
- 6: Kühlkörper

- H: Halbleitermodul

## Patentansprüche

1. Halbleitermodul, insbesondere Leistungshalbleitermodul, bei dem zumindest ein mit einem Substrat (1) verbundenes halbleitendes Bauelement (2) von einem aus einem Polymermaterial hergestellten Gehäuse (3) umgeben ist, wobei ein Zwischenraum zwischen dem halbleitenden Bauelement (2) und dem das halbleitende Bauelement (2) umgebenden Gehäuse (3) zumindest teilweise mit einer Vergussmasse (4) gefüllt ist,
**dadurch gekennzeichnet, dass**
das Polymermaterial eine aus einem präkeramischen Polymer gebildete duroplastische Matrix aufweist.

2. Halbleitermodul nach Anspruch 1, wobei die Vergussmasse (4) eine aus einem weiteren präkeramischen Polymer gebildete Matrix aufweist.

3. Halbleitermodul nach Anspruch 2, wobei das weitere präkeramische Polymer in gelartiger oder duroplastischer Form vorliegt.

4. Halbleitermodul nach einem der vorgehergehenden Ansprüche, wobei das präkeramische Polymer und/oder das weitere präkeramische Polymer mit einem Füllgrad von bis zu 80 Vol.% mit einem Füllstoff gefüllt ist.

5. Halbleitermodul nach einem der vorhergehenden Ansprüche, wobei der Füllstoff ein aus einem keramischen Material gebildetes Pulver mit einer mittleren Korngröße im Bereich von 0,5 bis 500 µm ist.

6. Halbleitermodul nach einem der vorhergehenden Ansprüche, wobei die Wärmeleitfähigkeit γ des keramischen Materials bei Raumtemperatur größer als 10 W/mK, vorzugsweise größer als 20 W/mK, ist.

7. Halbleitermodul nach einem der vorhergehenden Ansprüche, wobei das keramische Material aus der folgenden Gruppe ausgewählt ist: BN, SiC, Si₃N₄, AlN, Steatit, Cordierit.

8. Halbleitermodul nach einem der vorhergehenden Ansprüche, wobei das präkeramische Polymer und/oder das weitere präkeramische Polymer aus der folgenden Gruppe ausgewählt ist: Polysiloxan, Polysilazan, Polycarbosilan.

## Claims

1. A semiconductor module, in particular a power semiconductor module, in which at least one semiconducting component (2) connected to a substrate (1) is surrounded by a casing (3) made of a polymer material, wherein an intermediate space between the semiconducting component (2) and the casing (3) surrounding the semiconducting component (2) is filled at least partially with a potting compound (4), **characterised in that** the polymer material comprises a thermosetting plastic matrix formed from a pre-ceramic polymer.

2. The semiconductor module according to claim 1, wherein the potting compound (4) comprises a matrix formed from another pre-ceramic polymer.

3. The semiconductor module according to claim 2, wherein the further pre-ceramic polymer is present in gel-like or thermosetting plastic form.

4. The semiconductor module according to any one of the preceding claims, wherein the pre-ceramic polymer and/or the further pre-ceramic polymer is filled with a filler with a degree of filling of up to 80 vol.%.

5. The semiconductor module according to any one of the preceding claims, wherein the filler is a powder formed from a ceramic material having an average grain size in the range of 0.5 to 500 µm.

6. The semiconductor module according to any one of the preceding claims, wherein the thermal conductivity γ of the ceramic material at room temperature is greater than 10 W/mK, preferably greater than 20 W/mK.

7. The semiconductor module according to any one of the preceding claims, wherein the ceramic material is selected from the following group: BN, SiC, Si₃N₄, AlN, steatite, cordierite.

8. The semiconductor module according to any one of the preceding claims, wherein the pre-ceramic polymer and/or the further pre-ceramic polymer is selected from the following group: polysiloxane, polysilazane, polycarbosilane.

## Revendications

1. Module à semi-conducteurs, en particulier module à semi-conducteurs de puissance, sur lequel au moins un composant semi-conducteurs (2) relié à un substrat (1) est entouré d'un boitier (3) fabriqué à base d'un matériau polymère, un espace intermédiaire entre le composant (2) semi-conducteurs et le boitier (3) entourant le composant à semi-conducteurs (2) étant rempli au moins partiellement d'une masse de scellement (4),
**caractérisé en ce que** :
le matériau polymère présente une matrice thermodurcissable formée à base d'un polymère précéramique.

2. Module à semi-conducteurs selon la revendication 1, la masse de scellement (4) présentant une matrice formée dans un autre polymère précéramique.

3. Module à semi-conducteurs selon la revendication 2, l'autre polymère précéramique étant présent sous forme de gel ou thermodurcissable.

4. Module à semi-conducteurs selon l'une des revendications précédentes, le polymère précéramique et/ou l'autre polymère précéramique étant rempli d'une matière de charge avec un niveau de charge allant jusqu'à 80 % en volume.

5. Module à semi-conducteurs selon l'une des revendications précédentes, la matière de charge étant une poudre formée d'un matériau céramique avec une grosseur de grain moyenne de l'ordre de 0,5 à 500 µm.

6. Module à semi-conducteurs selon l'une des revendications précédentes, la conductibilité thermique γ du matériau céramique à la température ambiante étant supérieure à 10 W/mK, de préférence supérieure à 20 W/mK.

7. Module à semi-conducteurs selon l'une des revendications précédentes, le matériau céramique étant choisi dans le groupe suivant : BN, SiC, Si₃N₄, AlN, stéatite, cordiérite.

8. Module à semi-conducteurs selon l'une des revendications précédentes, le polymère précéramique et/ou l'autre polymère précéramique étant choisi dans le groupe suivant : polysiloxane, polysilazane, polycarbosilane.
